# EUROPEAN PATENT SPECIFICATION

(11) **EP 3 238 333 B1**
(45) Date of publication and mention of the grant of the patent: **29.05.2019**
(21) Application number: 14821187.3
(22) Date of filing: 23.12.2014
(51) Int. Cl.: H02M 7/00, H02M 7/04, H02M 7/48, H02M 1/32, H05K 7/14

(54) **MODULAR POWER CONVERTER**
MODULARER STROMWANDLER
CONVERTISSEUR DE PUISSANCE MODULAIRE

(43) Date of publication of application: 01.11.2017
(73) Proprietor: ABB Schweiz AG, 5400 Baden (CH)
(72) Inventor: HYTTINEN, Mats, S-771 43 Ludvika (SE); BRORSSON, Göran, S-722 31 Västerås (SE); SZEWCZYK, Marcin, PL-03-982 Warsaw (PL); LAZARCZYK, Michal, PL-30-348 Krakow (PL); DAWIDOWSKI, Pawel, PL-30-707 Krakow (PL); JEZ, Radoslaw, PL-44-240 Zory (PL); PIASECKI, Wojciech, PL-30-009 Krakow (PL)
(74) Representative: Lundqvist, Alida Maria Therése
(86) International application number: PCT/EP2014/079144
(87) International publication number: WO 2016/101997

(56) References cited:
- EP-A1- 2 579 438
- FR-A1- 2 954 618
- US-A1- 2010 208 446
- "SKM400GB12T4", , 3 September 2013 (2013-09-03), pages 1-5, XP055210900, Retrieved from the Internet: URL:http://www.semikron.com/dl/service-sup port/downloads/download/semikron-datasheet -skm400gb12t4-22892080 [retrieved on 2015-09-02]
- M HERNES ET AL: "Enabling pressure tolerant power electronic converters for subsea applications", 2009 13TH EUROPEAN CONFERENCE ON POWER ELECTRONICS AND APPLICATIONS, 2009, pages 1-10, XP055164790, ISBN: 978-1-42-444432-8

## Description

### TECHNICAL FIELD

The present disclosure relates generally to the field of power converters, such as high voltage power converters. The present disclosure relates in particular to a power converter having several branch units or phase-legs.

### BACKGROUND

A power converter is a type of converter adapted to convert direct current (DC) power, such as e.g. high voltage direct current (HVDC) to alternating current (AC) power or the reverse. A power converter may comprise a plurality of elements such as the converter itself (or a plurality of converter connected in series or in parallel), an alternating current switch gear, transformers, capacitors, filters and other auxiliary elements.

Power converters for e.g. high voltage applications and in particular offshore high voltage applications may be very heavy, reaching weights of 3,000,000 kg or more. Thus, handling and transport of such power converters may be difficult and expensive. Further, offshore sites may be located at relatively long distances from land. Transporting required for installation, maintenance and repairing of the power converter may therefore be time consuming.

Thus, a general challenge in the present technical field is to provide a power converter design, for e.g. offshore HVDC applications, which facilitates installation, transport and maintenance of the power converter. Further, there is a general need of improving reliability of operation and reducing down-time of the power converter.

Document FR2954618 discloses a three-phase inverter with an extra, redundant, phase branch that is employed when one of the three standard phase branches develops a fault.

Document US2010208446 discloses a subsea power converter with a voltage inverter including at least three phase modules connected to one another, each one specifically for the shaping of the current on one phase at the output of the voltage inverter.

### SUMMARY

An object of at least some embodiments of the present disclosure is to wholly or at least partly address the above mentioned issues.

This and other objects are achieved by means of a power converter and method as defined in the appended independent claims. Other embodiments are defined by the dependent claims.

According to a first general aspect, there is provided a power converter comprising a first node, a second node and at least three branch units. The first node is adapted to receive a direct current power and the second node is adapted to output a three-phase alternating current power. A branch unit is electrically connectable to the first node and the second node. Further, the branch unit is adapted to convert the received DC into a respective phase of the output three-phase AC, and arranged in a sealed enclosure which is separately arranged from sealed enclosures of the other branch units.

According to a second general aspect, there is provided a power converter comprising a first node adapted to output a direct current power, a second node adapted to receive a three-phase alternating current power, and at least three branch units. Further, a branch unit is electrically connectable to the first node and the second node, adapted to convert a respective phase of the received AC into DC, and arranged in a sealed enclosure which is separately arranged from sealed enclosures of the other branch units.

According to a third and fourth aspect, methods of operating a power converter according to the first and second aspects are provided in accordance with the subject-matter of the independent method claims.

The present disclosure provides a power converter which is modularized on phase-leg level, i.e. wherein a branch unit is associated with a respective AC phase and arranged in a separate, sealed enclosure, thus forming a separate branch unit module. This allows for the phase-leg modules, or branch unit modules, to be individually removed from the power converter for e.g. maintenance or to be replaced in the event of e.g. failure of operation. A power converter failure is likely to affect one or two of such modules rather than the entire power converter, whereby the affected branch unit module(s) may be removed or disconnected for repair or replacement. The modularized power converter may hence be handled in separate modules, thereby facilitating maintenance and transport which can be focused on a particular module instead of the power converter as a whole.

A more convenient handling and transport may be of particular interest for e.g. subsea applications, for which the conditions for transport and accessibility may be harsh, time consuming and expensive. As compared to power converters arranged in e.g. a single enclosure, the power converter according to the above embodiment provides branch unit modules that may be individually retrieved and handled. By arranging a branch unit in individual, sealed enclosures that are separately arranged from sealed enclosures of the other branch units, weight and size may be reduced during handling and transportation of the power converter. Hence, requirements such as e.g. load carrying capacity of a vessel used for handling and carrying a load of the branch unit module may be reduced.

Further, an improved accessibility of the power converter may allow for a faster maintenance, repair or replacement of failed parts or the power converter, which may reduce the down-time of the power converter.

By the term sealed enclosure is meant a structure surrounding a branch unit and being sealed to protect the branch unit from the surrounding environment. The sealed enclosure may be hermetically sealed so as to prevent water from entering the enclosure and reaching the enclosed branch unit. This is advantageous in e.g. subsea applications, wherein the power converter may be arranged on the seabed. The sealed enclosure may also be referred to as a receptacle, tank, container or vessel adapted to receive a branch unit of a power converter, thereby forming a branch unit module or phase-leg module.

A branch unit may be referred to as a building block or valve unit, and may be formed of one or several converter cells using transistors, such as insulated gate bipolar transistors (IGBTs), as switches (or switching devices). A branch unit may also include additional components such as capacitors, inductors, control circuits, measurement circuits and other auxiliary systems.

The first node may also be referred to as a DC node which may be adapted to output or receive DC, whereas the second node may be referred to as an AC node adapted to receive or output three-phase AC.

According to the invention, the power converter comprises at least one redundant branch unit arranged in a separate, sealed enclosure and adapted to be interchangeable with any one of the at least three branch units. The sealed enclosure of the redundant branch unit may be similarly configured as the sealed enclosures previously described for the three other branch units. A redundant branch unit should be understood as an extra or spare branch unit which does not necessarily participate in a normal operation of the power converter, or at least is passive during operation of the at least three branch units. Further, the redundant branch unit may be adapted to convert DC into a phase of the three-phase AC or vice versa. The redundant branch unit may therefore replace any one of the at least three branch units.

According to an embodiment, the redundant branch unit may be configured to act as one of the at least three branch units in case of failure or maintenance of that particular branch unit. The redundant branch unit may hence replace a failed branch unit or a branch unit undergoing service so as to allow for the power converter to continue or resume its operation. As a result, down-time may be reduced and maintenance may be planned in advance to reduce cost. It will also be appreciated that the power converter may comprise two or more of such redundant branch units which can be used to further prolong the time between planned maintenance and to reduce down-time of the power converter.

In case of a failure in one of the three branch units, the power converter may be shut down, the spare branch unit connected to replace the failed branch unit, and the power converter started over again. The redundant branch unit may be used as a temporary replacement unit during the time it takes to prepare a new branch unit. A redundancy of the power converter may thus be achieved without using an entire power converter as a back-up or replacement unit. The modular power converter design hence provides a redundancy at a phase-leg level, thereby allowing for a reduction of cost.

According to an embodiment, each one of the at least three branch units may be connected to the second node via a respective phase line. Further, a switch may be provided to electrically connect and disconnect a branch unit with its respective phase line. During normal operation, each output switch may be closed so as to connect the respective branch unit with its phase line and hence the second node. The switch may however be used for disconnecting a branch unit from its phase line in response to e.g. a failure in operation, a planned maintenance or service of that branch unit. If a redundant branch unit is available, it may be connected to the second node to replace the disconnected branch unit at least temporarily until the disconnected branch unit is replaced or operable again.

According some embodiments, the power converter may comprise a switchgear for electrically connecting and disconnecting the redundant branch unit with any one of the phase lines. The switchgear may e.g. include three switches that are adapted to electrically connect and disconnect the redundant branch unit with a respective phase line. Further, a node switch may be arranged to electrically connect and disconnect a branch unit with the first node. In one example, one or several switchgears may be adapted to electrically connect and disconnect one or several of the at least three branch units from any one of the phase lines. In case each one of the branch units of the power converter may be connected and disconnected to any one of the phase lines, each one of the branch units may act as a redundant branch unit.

A replacement of a branch unit may be realized by disconnecting the branch unit from the first node by means of the node switch and from the second node, or the respective phase line, by means of the phase line switch. The redundant branch unit may then be brought into operational mode by means of the switchgear connecting the redundant branch unit to the particular phase line from which the replaced branch unit was disconnected.

According to an embodiment, the switchgear may be remotely controllable. The replacement of any one of the at least three branch units may hence be controlled from a remote position, i.e. without people or a robot physically accessing the power converter. This is particularly advantageous for subsea applications, in which access to the power converter may be time consuming and expensive.

According to an embodiment, the branch units may be connected to each other by means of wet-mateable connectors, i.e. connectors that may be mated and de-mated in a subsea environment. Mounting, removal and replacement of the branch unit modules of the power converter under water may therefore be facilitated. In particular, it allows a branch unit to be removed from a subsea power converter while the power converter is still in operation. It will also be appreciated that the branch units may be connected to each other by means of dry-mateable connectors. In such case, a subsea power converter may be lifted to the surface of the sea prior to mounting, removal and replacement of the branch unit modules.

According to an embodiment, a branch unit may comprise at least two converter arms and at least two reactors or capacitors. A converter arm may comprise a plurality of arm valves, in which a plurality of switching devices may be connected in series. The switching devices may be semiconductor-based switching devices. By way of example, the switching devices may be an insulated-gate bipolar transistor (IGBT), a metal-oxide-semiconductor field-effect transistor (MOSFET), an integrated gate-commutated thyristor (IGCT), a gate turn-off thyristor (GTO), a high electron mobility transistor (HEMT) and a hetero junction bipolar transistor (HBT). Other types of transistors (or semiconductor-based switching devices) may be envisaged.

Further, it will be appreciated that the present disclosure is not limited to a specific semiconductor technology. It will be appreciated that switching devices based on silicon or silicon carbide may be employed, in particular for MOSFETs, IGBTs, IGCTs and GTOs as examples. Switching devices based on Gallium Nitride or Gallium Arsenide may also be employed, in particular for HEMTs or HBTs as examples. Other types of semiconductors providing switching devices for high power applications may be envisaged.

It will be appreciated that the converter arms may further comprise other electric components or devices. For example, the converter cell may also include a cooling device and/or a by-pass switch which allows a current to bypass the switching devices of a converter cell upon failure of a switching device, thereby reducing the risk of damages of the components of a converter cell, e.g. caused by short circuit currents. The bypass switch may be a mechanical switch or a solid state switch such as for example a thyristor. Further, the converter cell may also include means for reducing the failure currents.

According to some embodiments, the power converter may be a HVDC power converter adapted to receive or output a HVDC. The HVDC may e.g. be received from an onshore power source and the power converter may be arranged on a seabed.

According to the invention, the method of operating the power converter comprises the steps of disconnecting, in response to a detected failure in operation or maintenance of a branch unit, the branch unit from the first node and the second node, and replacing the disconnected branch unit with a redundant branch unit arranged in a separate, sealed enclosure by connecting the redundant branch unit with the first node and with a corresponding phase line of the second node.

The present disclosure is applicable for power converters with various voltage levels, such as e.g. HVDC power converters but also medium voltage equipments, in which it is desired to improve reliability of operation and reduce down-time. The present disclosure is advantageous in any power converters wherein a more convenient installation, transport and maintenance is desired, such as in subsea applications.

It will be appreciated that other embodiments using all possible combinations of features recited in the above described embodiments may be envisaged.

### BRIEF DESCRIPTION OF THE DRAWING

Exemplifying embodiments will now be described in more detail, with reference to the following appended drawings:
Figure 1 shows a schematic circuit of a power converter connected to a power source and a load in accordance with an embodiment;
Figure 2 shows a schematic power converter according to other embodiments;
Figure 3 shows a schematic branch unit in accordance with some embodiments;
Figure 4 is a schematic three-dimensional view of a power converter in accordance with some embodiments; and
Figure 5 is a flow chart illustrating a method of operating a power converter according to some embodiments.

As illustrated in the figures, the sizes of the elements, modules and regions may be exaggerated for illustrative purposes and, thus, are provided to illustrate the general structures of the embodiments. Like reference numerals refer to like elements throughout.

### DETAILED DESCRIPTION

Exemplifying embodiments will now be described more fully hereinafter with reference to the accompanying drawings, in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

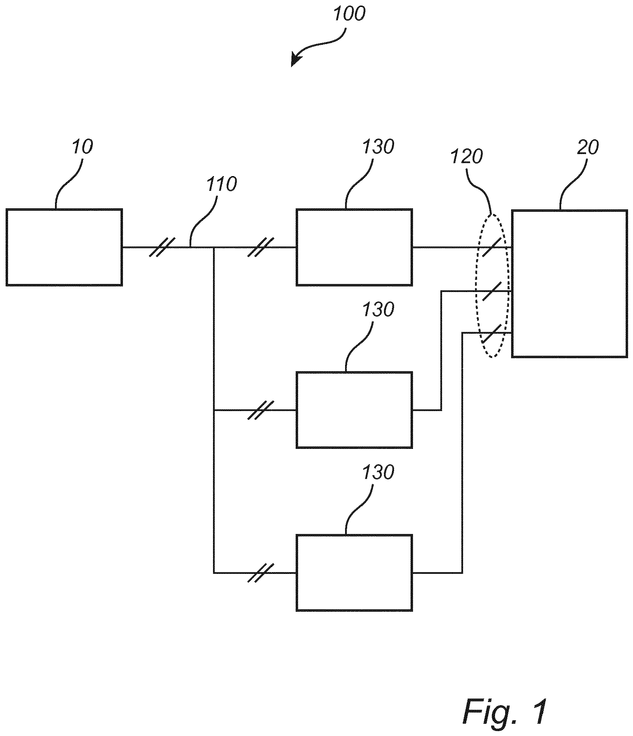

With reference to Figure 1, a power converter 100 according to an embodiment is described.

Figure 1 shows a schematic power converter 100 adapted to receive a DC, such as a HVDC, from a power electric equipment such as a power source 10 and to output a three-phase AC to a load 20. The load 20 may refer to a single electrical load or a plurality of electrical loads. The load 20 may e.g. be supplied with electrical power via an electrical grid powered by the power converter 100. In one example, the power converter 100 may be arranged in a subsea environment and the power source 10 arranged onshore. The power converter may comprise a first node 110 or transmission line adapted to receive DC from the power source 10, and a second node 120 or transmission line adapted to output converted three-phase AC to a load 20. Further, the power converter 100 may comprise three branch units 130 or phase-legs, each of which being electrically connectable to the first node 110 and the second node 120. As shown in Figure 1, the DC terminals of the three branch units 130 may be connected in parallel. The three branch units 130 may be adapted to convert the DC received at the DC terminals into a respective phase of the three-phase AC and output the phases to the second node 120. Each one of the three branch units 130 may be arranged in a sealed enclosure, such as a hermetically sealed container (not shown in Figure 1), which may be separately arranged from the enclosures of the other branch units 130.

During operation, DC may be supplied to the power converter 100 from the power source 10 via the first node or DC node 110. At each one of the three branch units 130 the received DC may be converted into a respective phase of a three-phase AC, and supplied to the load 20 via the second node or the AC node 120. The power converter 100 may be configured to operate in a reverse direction, i.e. to receive and convert a three-phase AC into a DC, such as e.g. a HVDC. In such case, the three-phase AC may be received at the second node 120 from which each one of the phases is supplied to the respective branch unit 130. At the branch units 130, the respective phases may be converted into a DC and output via the first node 110.

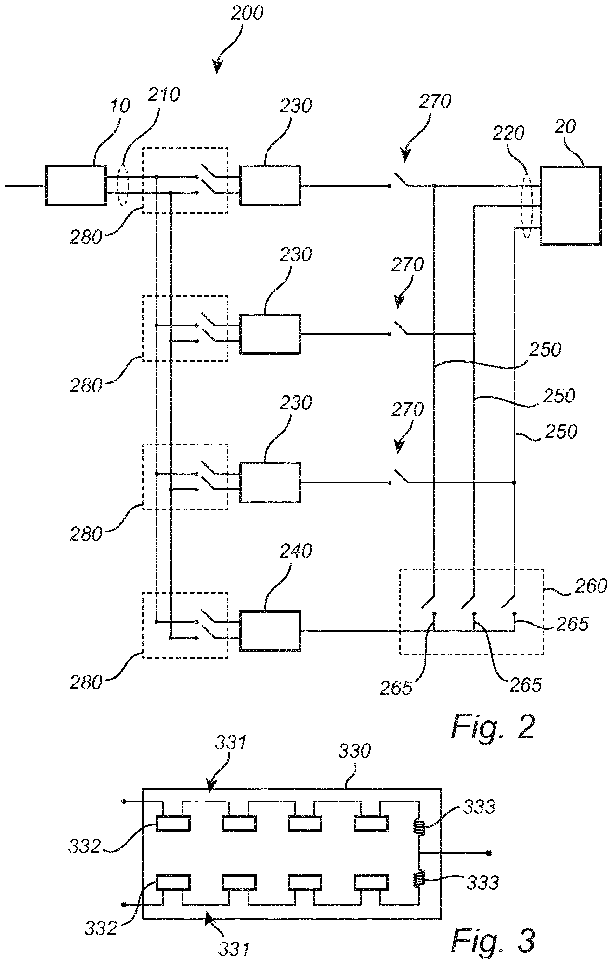

It will also be appreciated that two or more power converters 100 may be connected in parallel, wherein each one of the power converters 100 may be arranged to supply AC and DC to a respective load, a group of loads, or a plurality of separate groups. Figure 2 shows a schematic power converter 200 according to embodiments. The power converter 200 may be similarly configured as the power converter described with reference to Figure 1. Hence, the power converter may be adapted to receive a DC at the first node 210, convert the received DC into a three-phase AC by means of three phase-legs or branch units 230, and output the converted AC at a second node 220.

According to the embodiment shown in Figure 2, the power converter 200 further comprises a redundant phase-leg or branch unit 240, which may be similarly configured as any one of the three branch units 230 described above with reference to Figure 1. The redundant branch unit 240 may be arranged to not take part in a normal operation of the power converter 200 in the sense that it is initially disconnected from the circuit, or at least from the second node, but may be interchangeable with any one of the three branch units 230. The redundant branch unit may hence replace any one of the three branch units 230, thus acting in its place.

Each one of the three branch units 230 may be electrically connected to a respective phase line 250 connecting the respective branch unit 230 to the second node 220. Further, a branch unit 230 may be connected and disconnected with its respective phase line 250 by a phase line switch 270. The power converter 200 may also comprise node switches 280 arranged to connect and disconnect a branch unit 230 with the first node 210.

A switchgear 260, e.g. comprising a switch 265 for each phase line 250, may be arranged to connect and disconnect the redundant branch unit 240 with any one of the phase lines 250. A node switch 280 may also be arranged to connect and disconnect the redundant branch unit with the first node 210.

The phase line switches 270 and/or node switches 280 may be used for disconnecting any one of the three branch units 230 upon e.g. failure in operation, maintenance or replacement of that branch unit 230. Further, the redundant branch unit 240 may be connected to the first node 210 by the node switch 280 and to the corresponding phase line 250 by the switchgear 260, thereby acting as the disconnected branch unit 230.

With reference to Table 1, an operating scheme of the node switches 280, the phase line switches 270 and the switchgear 260 will now be described. S_{IN1}, S_{IN2} and S_{IN3} denote the node switches 280 at the first, second and third branch units 230, respectively, whereas S_{OUT1}, S_{OUT2}, and S_{OUT3} denotes the phase line switches 270 at the first, second and third branch units 230, respectively. Further, S_{IN4} denotes the node switch 280 at the redundant branch unit 240 and S_{RED1}, S_{RED2} and S_{RED3} represent the switches 265 of the switchgear 260, connecting and disconnecting the redundant branch unit 240 to the first, second and third phase line 250, respectively. In Table 1, "ON" represents a closed switch (i.e. a conducting switch) and "OFF" an open switch (i.e. a non-conducting switch).

**Table 1**

| | S_{IN1} | S_{IN2} | S_{IN3} | S_{OUT1} | S_{OUT2} | S_{OUT3} | S_{IN4} | S_{RED1} | S_{RED2} | S_{RED3} |
|---|---|---|---|---|---|---|---|---|---|---|
| Normal operation | ON | ON | ON | ON | ON | ON | OFF | OFF | OFF | OFF |
| Hot standby | ON | ON | ON | ON | ON | ON | ON | OFF | OFF | OFF |
| Fault in phase 1 | OFF | ON | ON | OFF | ON | ON | ON | ON | OFF | OFF |
| Fault in phase 2 | ON | OFF | ON | ON | OFF | ON | ON | OFF | ON | OFF |
| Fault in phase 3 | ON | ON | OFF | ON | ON | OFF | ON | OFF | OFF | ON |

During normal operation of the power converter 200, all node switches S_{IN1}, S_{IN2} and S_{IN3} and all phase line switches S_{OUT1}, S_{OUT2}, and S_{OUT3} are in an ON state. Each one of the three branch units 230 is thereby connected to the first node 210 and the second node 220 and hence in an operating mode. As shown in Table 1, the redundant branch unit 240 may be disconnected from the first node 210 by switch S_{IN4} and from the second node by switches S_{RED1}, S_{RED2} and S_{RED3}. The redundant branch unit 240 may hence be in a non-operating or passive mode.

Alternatively, the redundant branch unit 240 may be arranged in a hot standby mode, wherein the redundant branch unit 240 is electrically connected to node 210 by node switch S_{IN4}, but disconnected from the second node 220 by switches S_{RED1}, S_{RED2} and S_{RED3}. The hot standby mode may allow for a faster replacement or transition process as the redundant branch unit 240 is being installed in the place of any one of the three branch units 230.

Upon e.g. a fault in the first phase of the power converter 200, e.g. caused by a failure in operation of the first one of the three branch units 230, the first one of the branch units 230 may be disconnected by node switch S_{IN1} and phase line switch S_{OUT1}. In this case, the redundant branch unit 240 may be connected to the first node 210 by node switch S_{IN4} and to the first phase line of phase lines 250 by switch S_{RED1} of the switchgear 260. The redundant branch unit 240 may hence act as the disconnected first one of the three branch units 230.

In a similar way, the second one of the three branch units 230 may be disconnected by switches S_{IN2} and S_{OUT2} upon a fault in the second phase, and the redundant branch unit 240 connected to the first node 210 by switch S_{IN4} and the second one of the phase lines 250 by switch S_{RED2} of the switchgear 260.

In case there is a fault or failure in the third phase, the third one of the three branch units 230 may be disconnected by node switch S_{IN3} and phase line switch S_{OUT3} and the redundant branch unit 240 inserted in operation by switches S_{IN4} and S_{RED3} so as to act as the third one of the three branch units 230.

As previously discussed with reference to Figure 1, the power converter 200 may in an alternative embodiment be configured to operate in a reverse direction, i.e. to receive and convert a three-phase AC into a DC, such as e.g. a HVDC. In such case, the power converter 200 may differ in that the three-phase AC may be supplied to the second node 220, converted by the respective branch units 230 and output as a DC at the first node 210.

Figure 3 schematically shows a branch unit 330 similarly configured as the branch units described with reference to Figure 1 and 2. The branch unit 330 may comprise two converter arms 331, each of which having a plurality of valves 332 connected in series. Further, the converters arms 332 may be connected in series with a respective reactor 333, such as e.g. a coil. Each converter arm 331 may be configured to receive (or output) a DC and to output (or receive) a phase of a three-phase AC. Each valve 332 may comprise one or several semiconductor-based switching devices, such as e.g. IGBTs, MOSFETs and thyristors (not shown in Figure 3).

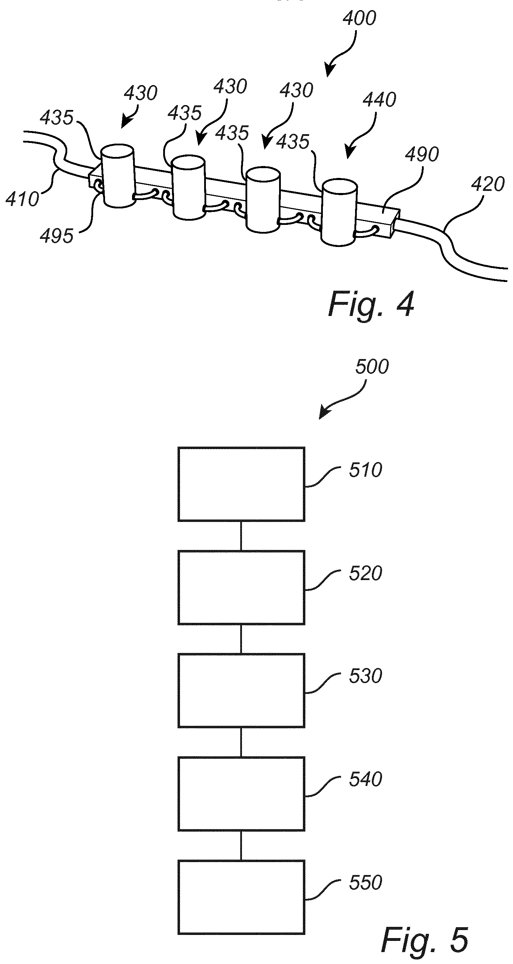

With reference to Figure 4, a power converter 400 according to an embodiment is described. The power converter 400 may be similarly configured as the power converters described with reference to Figures 1 and 2.

Figure 4 shows a perspective view of a power converter coupled to a first node or DC transmission line 410 and a second node or AC transmission line 420. The power converter 400 may e.g. be a subsea HVDC power converter arranged at a seabed, and may comprise three branch unit modules 430 and a redundant branch unit module 440. A branch unit module 430 may be formed of a branch unit (not shown) arranged in a sealed enclosure 435. Similarly, the redundant branch unit module 440 may be formed of a redundant branch unit (not shown) enclosed by a sealed enclosure 435. The sealed enclosures 435 may be arranged separately from each other so as to allow for any one of them to be removed and/or replaced.

The branch unit modules 430 and the redundant branch unit module 440 may be electrically coupled to a coupling rack 490, which may be configured to hold electric equipment such as e.g. node switches, phase line switches, and a switchgear. Further, the coupling rack 490 may be connected to or may include the first node 410 and the second node 420. Each one of the modules 430, 440 may be electrically coupled to each other via the coupling rack 490 by means of wet-mateable connectors 495. As a result, any one of the modules 430, 440 may be removed and/or installed in a subsea environment. Hence, handling and maintenance of the power converter 400 may be facilitated and the down-time reduced.

Figure 5 is a flow chart illustrating a method 500 of operating a power converter according to some embodiments. The power converter may be similarly configured as the power converters described with reference to Figures 2 and 4.

The method 500 comprises the steps of receiving 510 a DC at a first node and converting 520 the DC into a three-phase AC. The conversion may be achieved by means of at least three branch units which are electrically connectable to a first node and to a second node, at which the converted AC may be output 530.

In an alternative embodiment, the method 500 may be adapted to operate a power converter for to converting a three-phase AC into a DC. In such case, the method 500 may comprise the steps of receiving 510 a three-phase AC at the first node, converting 520 the AC into a DC, and output 530 the DC at the second node.

The method also comprises the further steps of disconnecting 540 a branch unit from the first node and the second node in response to a detected failure in operation or maintenance, and replacing 550 the disconnected branch unit with a redundant branch unit with the first node and the second node via a corresponding phase line.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims.

The claimed invention may be combined with a control device or system adapted to control the operation of one or several of the switchgear, the branch units, the node switches and/or the phase line switches. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A subsea power converter (100, 200, 400) adapted to receive a direct current (DC) via a first transmission line (110, 210, 410) and adapted to output a three-phase alternating current (AC) via a second transmission line (120, 220, 420), said power converter comprising:
at least three branch units (130, 230), wherein a branch unit is:
electrically connectable to the first transmission line and the second transmission line; and
adapted to convert the received DC into a respective phase of the output three-phase AC;
**characterised in that** each branch unit (130, 230) is arranged in a sealed enclosure (435) which is separately arranged from sealed enclosures of the other branch units: and said power converter further comprises at least one redundant branch unit (140, 240) that is arranged in a separate, sealed enclosure and is interchangeable with any one of said at least three branch units.

2. A subsea power converter (100, 200, 400) adapted to output a direct current (DC) via a first transmission line (110, 210, 410) and adapted to receive a three-phase alternating current (AC) via a second transmission line (120, 220, 420), said power converter comprising:
at least three branch units (130, 230), wherein a branch unit is:
electrically connectable to the first transmission line and the second transmission line; and ;
adapted to convert a respective phase of the received AC into DC;
**characterised in that** each branch unit (130, 230) is arranged in a sealed enclosure (435) which is separately arranged from sealed enclosures of the other branch units; and said power converted further comprises at least one redundant branch unit (140, 240) that is arranged in a separate, sealed enclosure and is interchangeable with any one of said at least three branch units.

3. The power converter of claim 1 or 2, wherein the redundant branch unit is configured to act as one of said at least three branch units in case of failure or maintenance of said one of said at least three branch units.

4. The power converter of any one of the preceding claims, wherein each one of said at least three branch units is adapted to be connected to the second transmission line via a respective phase line (250), and wherein the power converter comprises at least one phase line switch (270) adapted to electrically connect and disconnect a branch unit with its respective phase line.

5. The power converter of any one of the preceding claims, further comprising a switchgear (260) for electrically connecting and disconnecting the redundant branch unit with any one of said phase lines.

6. The power converter of claim 5, wherein the switchgear includes three switches (265) adapted to electrically connect and disconnect the redundant branch unit with a respective phase line.

7. The power converter of claim 5, wherein each one of said at least three branch units is connected to a respective switchgear that includes switches adapted to electrically connect and disconnect the respective branch unit with any one of said phase lines.

8. The power converter of any one of claims 5 to 7, wherein the switchgear is remotely controllable.

9. The power converter of any one of the preceding claims, comprising at least one node switch (280) for electrically connecting and disconnecting a branch unit with the first transmission line.

10. The power converter of any one of the preceding claims, wherein the branch units are connected to each other by means of wet-mateable or dry-mateable connectors (495).

11. The power converter of any one of the preceding claims, wherein a branch unit comprises at least two converter arms (331) and at least two reactors (333).

12. The power converter of any one of the preceding claims, wherein the power converter is a high voltage direct current (HVDC) power converter.

13. The power converter of any one of the preceding claims, adapted to receive/transmit a DC/AC from/to an onshore power electric equipment (20).

14. Method (500) of operating a subsea power converter, comprising the steps of:
receiving (510) a direct current (DC);
converting (520) the received DC into a three-phase alternating current (AC) by means of at least three branch units, wherein a branch unit is electrically connectable to a first transmission line for receiving the DC and a second transmission line for outputting the AC, the branch unit being further adapted to convert the received DC into a respective phase of the output three-phase AC; and
outputting (530) a three-phase AC;
**characterised by**
each branch unit being arranged in a sealed enclosure which is separately arranged from sealed enclosures of the other branch units;
and by the steps of:
in response to a detected failure in operation or maintenance of a branch unit, disconnecting (540) said branch unit from the first transmission line and the second transmission line; and
replacing (550) said branch unit with a redundant branch unit, comprised in the subsea power converter and arranged in a separate, sealed enclosure, by connecting the redundant branch unit with the first transmission line and with a corresponding phase line of the second transmission line.

15. Method (500) of operating a subsea power converter, comprising the steps of:
receiving (510) a three-phase alternating current (AC);
converting (520) the received AC into a direct current (DC) by means of at least three branch units, wherein a branch unit is electrically connectable to the first transmission line for outputting the DC and a second transmission line for receiving the AC, the branch unit being further adapted to convert a respective phase of the received three-phase AC into DC; and outputting (530) a DC;
**characterised by**
each branch unit being arranged in a sealed enclosure which is separately arranged from sealed enclosures of the other branch units;
and by the steps of:
in response to a detected failure in operation or maintenance of a branch unit, disconnecting (540) said branch unit from the first transmission line and the second transmission line;
replacing (550) said branch unit with a redundant branch unit, comprised in the subsea power converter and arranged in a separate, sealed enclosure, by connecting the redundant branch unit with the first transmission line and with a corresponding phase line of the second transmission line; and
outputting (530) a DC.

## Patentansprüche

1. Unterwasserstromrichter (100, 200, 400), der geeignet ist, um über eine erste Übertragungsleitung (110, 210, 410) einen Gleichstrom (DC) zu empfangen, und der geeignet ist, um über eine zweite Übertragungsleitung (120, 220, 420) einen Wechselstrom (AC) auszugeben, wobei der Stromrichter umfasst:
mindestens drei Verzweigungseinheiten (130, 230), wobei eine Verzweigungseinheit:
an die erste Übertragungsleitung und die zweite Übertragungsleitung elektrisch anschließbar ist; und
geeignet ist, um den empfangenen DC in eine entsprechende Phase des ausgegebenen Drei-Phasen-AC zu wandeln;
**dadurch gekennzeichnet, dass**
jede Verzweigungseinheit (130, 230) in einer abgedichteten Umhüllung (435) angeordnet ist, die getrennt von den abgedichteten Umhüllungen der anderen Verzweigungseinheiten angeordnet ist; und
der Stromrichter außerdem mindestens eine redundante Verzweigungseinheit (140, 240) umfasst, die in einer getrennten, abgedichteten Umhüllung angeordnet ist, und mit jeder der anderen mindestens drei Verzweigungseinheiten austauschbar ist.

2. Unterwasserstromrichter (100, 200, 400), der geeignet ist, um über eine erste Übertragungsleitung (110, 210, 410) einen Gleichstrom (DC) auszugeben, und der geeignet ist, um über eine zweite Übertragungsleitung (120, 220, 420) einen Wechselstrom (AC) zu empfangen, wobei der Stromrichter umfasst:
mindestens drei Verzweigungseinheiten (130, 230), wobei eine Verzweigungseinheit:
an die erste Übertragungsleitung und die zweite Übertragungsleitung elektrisch anschließbar ist; und
geeignet ist, um eine entsprechende Phase des empfangenen AC in einen DC zu wandeln;
**dadurch gekennzeichnet, dass**
jede Verzweigungseinheit (130, 230) in einer abgedichteten Umhüllung (435) angeordnet ist, die getrennt von den abgedichteten Umhüllungen der anderen Verzweigungseinheiten angeordnet ist; und
der Stromrichter außerdem mindestens eine redundante Verzweigungseinheit (140, 240) umfasst, die in einer getrennten, abgedichteten Umhüllung angeordnet ist, und mit jeder der anderen mindestens drei Verzweigungseinheiten austauschbar ist.

3. Stromrichter nach Anspruch 1 oder 2, wobei die redundante Verzweigungseinheit konfiguriert ist zum Funktionieren als eine der mindestens drei Verzweigungseinheiten im Falle eines Ausfalls oder einer Wartung der einen der mindestens drei Verzweigungseinheiten.

4. Stromrichter nach einem der vorhergehenden Ansprüche, wobei jede der mindestens drei Verzweigungseinheiten geeignet ist, um über eine entsprechende Phasenleitung (250) mit der zweiten Übertragungsleitung verbunden zu werden, und wobei der Stromrichter mindestens einen Phasenleitungsschalter (270) umfasst, der geeignet ist, um eine Verzweigungseinheit mit ihrer entsprechenden Phasenleitung zu verbinden oder sie davon zu trennen.

5. Stromrichter nach einem der vorhergehenden Ansprüche, der außerdem eine Schaltanlage (260) umfasst, um die redundante Verzweigungseinheit mit einer der Phasenleitungen elektrisch zu verbinden oder sie davon zu trennen.

6. Stromrichter nach Anspruch 5, wobei die Schaltanlage drei Schalter (265) umfasst, die geeignet sind, um die redundante Verzweigungseinheit mit einer entsprechenden Phasenleitung elektrisch zu verbinden oder sie davon zu trennen.

7. Stromrichter nach Anspruch 5, wobei jede der mindestens drei Verzweigungseinheiten mit einer entsprechenden Schaltanlage verbunden ist, die Schalter umfasst, die geeignet sind, um die entsprechende Verzweigungseinheit mit einer der Phasenleitung elektrisch zu verbinden oder sie davon zu trennen.

8. Stromrichter nach einem der Ansprüche 5 bis 7, wobei die Schaltanlage fernsteuerbar ist.

9. Stromrichter nach einem der vorhergehenden Ansprüche, der mindestens einen Knotenschalter (280) umfasst, um eine Verzweigungseinheit mit der ersten Übertragungsleitung elektrisch zu verbinden oder sie davon zu trennen.

10. Stromrichter nach einem der vorhergehenden Ansprüche, wobei die Verzweigungseinheiten mithilfe von nass steckbaren oder trocken steckbaren Steckverbindern (495) miteinander verbunden sind.

11. Stromrichter nach einem der vorhergehenden Ansprüche, wobei eine Verzweigungseinheit mindestens zwei Stromrichterarme (331) und mindestens zwei Reaktoren (333) umfasst.

12. Stromrichter nach einem der vorhergehenden Ansprüche, wobei der Stromrichter ein Hochspannungsgleichstromrichter (High-Voltage Direct Current power Converter, HVDC-Stromrichter) ist.

13. Stromrichter nach einem der vorhergehenden Ansprüche, der geeignet ist, um einen DC/AC von einer landgestützten elektrischen Stromanlage (20) zu empfangen oder dorthin zu übertragen.

14. Verfahren (500) zum Betreiben eines Unterwasserstromrichters, das die folgenden Schritte umfasst:
Empfangen (510) eines Gleichstroms (DC);
Wandeln (520) des empfangenen DC in einen Drei-Phasen-Wechselstrom (AC) mithilfe von mindestens drei Verzweigungseinheiten, wobei eine Verzweigungseinheit an eine erste Übertragungsleitung elektrisch anschließbar ist, um den DC zu empfangen, und an eine zweite Übertragungsleitung elektrisch anschließbar ist, um den AC auszugeben, wobei die Verzweigungseinheit außerdem geeignet ist, um den empfangenen DC in eine entsprechende Phase des ausgegebenen Drei-Phasen-AC zu wandeln; und
Ausgeben (530) eines Drei-Phasen-AC
**dadurch gekennzeichnet, dass**
jede Verzweigungseinheit in einer abgedichteten Umhüllung angeordnet ist, die getrennt von den abgedichteten Umhüllungen der anderen Verzweigungseinheiten angeordnet ist; und
wobei das Verfahren außerdem die folgenden Schritte umfasst:
als Reaktion auf einen erkannten Betriebsausfall oder auf eine Wartung einer Verzweigungseinheit, Trennen (540) der Verzweigungseinheit von der ersten Übertragungsleitung und von der zweiten Übertragungsleitung; und
Ersetzen (550) der Verzweigungseinheit durch eine redundante Verzweigungseinheit, die in dem Unterwasserstromrichter enthalten ist und in einer getrennten, abgedichteten Umhüllung angeordnet ist, indem die redundante Verzweigungseinheit mit der ersten Übertragungsleitung und mit einer entsprechenden Phase der zweiten Übertragungsleitung verbunden wird.

15. Verfahren (500) zum Betreiben eines Unterwasserstromrichters, das die folgenden Schritte umfasst:
Empfangen (510) eines Drei-Phasen-Wechselstroms (AC);
Wandeln (520) des empfangenen AC in einen Gleichstrom (DC) mithilfe von mindestens drei Verzweigungseinheiten, wobei eine Verzweigungseinheit an eine erste Übertragungsleitung elektrisch anschließbar ist, um den DC auszugeben, und an eine zweite Übertragungsleitung elektrisch anschließbar ist, um den AC zu empfangen, wobei die Verzweigungseinheit außerdem geeignet ist, um eine entsprechende Phase des empfangenen Drei-Phasen-AC in einen DC zu wandeln; und
Ausgeben (530) eines DC;
**dadurch gekennzeichnet, dass**
jede Verzweigungseinheit in einer abgedichteten Umhüllung angeordnet ist, die getrennt von den abgedichteten Umhüllungen der anderen Verzweigungseinheiten angeordnet ist; und
wobei das Verfahren außerdem die folgenden Schritte umfasst:
als Reaktion auf einen erkannten Betriebsausfall oder auf eine Wartung einer Verzweigungseinheit, Trennen (540) der Verzweigungseinheit von der ersten Übertragungsleitung und von der zweiten Übertragungsleitung;
Ersetzen (550) der Verzweigungseinheit durch eine redundante Verzweigungseinheit, die in dem Unterwasserstromrichter enthalten ist und in einer getrennten, abgedichteten Umhüllung angeordnet ist, indem die redundante Verzweigungseinheit mit der ersten Übertragungsleitung und mit einer entsprechenden Phase der zweiten Übertragungsleitung verbunden wird; und
Ausgeben (530) eines DC.

## Revendications

1. Convertisseur de puissance sous-marin (100, 200, 400) adapté pour recevoir un courant continu (CC) par le biais d'une première ligne de transmission (110, 210, 410) et adapté pour délivrer un courant alternatif (CA) triphasé par le biais d'une deuxième ligne de transmission (120, 220, 420), ledit convertisseur de puissance comprenant :
au moins trois unités de dérivation (130, 230), une unité de dérivation étant :
branchable électriquement à la première ligne de transmission et la deuxième ligne de transmission ; et
adaptée pour convertir le CC reçu en une phase respective du CA triphasé délivré ;
**caractérisé en ce que**
chaque unité de dérivation (130, 230) est disposée dans une enceinte scellée (435) qui est disposée séparément d'enceintes scellées des autres unités de dérivation ; et
ledit convertisseur de puissance comprend en outre au moins une unité de dérivation redondante (140, 240) qui est disposée dans une enceinte scellée séparée et est interchangeable avec l'une quelconque desdites au moins trois unités de dérivation.

2. Convertisseur de puissance sous-marin (100, 200, 400) adapté pour délivrer un courant continu (CC) par le biais d'une première ligne de transmission (110, 210, 410) et adapté pour recevoir un courant alternatif (CA) triphasé par le biais d'une deuxième ligne de transmission (120, 220, 420), ledit convertisseur de puissance comprenant :
au moins trois unités de dérivation (130, 230), une unité de dérivation étant :
branchable électriquement à la première ligne de transmission et la deuxième ligne de transmission ; et
adaptée pour convertir une phase respective du CA reçu en CC ;
**caractérisé en ce que**
chaque unité de dérivation (130, 230) est disposée dans une enceinte scellée (435) qui est disposée séparément d'enceintes scellées des autres unités de dérivation ; et
ledit convertisseur de puissance comprend en outre au moins une unité de dérivation redondante (140, 240) qui est disposée dans une enceinte scellée séparée et est interchangeable avec l'une quelconque desdites au moins trois unités de dérivation.

3. Convertisseur de puissance de la revendication 1 ou 2, dans lequel l'unité de dérivation redondante est configurée pour agir comme une desdites au moins trois unités de dérivation en cas de défaillance ou de maintenance de ladite une desdites au moins trois unités de dérivation.

4. Convertisseur de puissance de l'une quelconque des revendications précédentes, chacune desdites au moins trois unités de dérivation étant adaptée pour être branchée à la deuxième ligne de transmission par le biais d'une ligne de phase respective (250), et le convertisseur de puissance comprenant au moins un commutateur de ligne de phase (270) adapté pour brancher et débrancher électriquement une unité de dérivation avec sa ligne de phase respective.

5. Convertisseur de puissance de l'une quelconque des revendications précédentes, comprenant en outre un appareillage de commutation (260) pour brancher et débrancher électriquement l'unité de dérivation redondante avec l'une quelconque desdites lignes de phase.

6. Convertisseur de puissance de la revendication 5, dans lequel l'appareillage de commutation comporte trois commutateurs (265) adaptés pour brancher et débrancher électriquement l'unité de dérivation redondante avec une ligne de phase respective.

7. Convertisseur de puissance de la revendication 5, dans lequel chacune desdites au moins trois unités de dérivation est branchée à un appareillage de commutation respectif qui comporte des commutateurs adaptés pour brancher et débrancher électriquement l'unité de dérivation respective avec l'une quelconque desdites lignes de phase.

8. Convertisseur de puissance de l'une quelconque des revendications 5 à 7, dans lequel l'appareillage de commutation est contrôlable à distance.

9. Convertisseur de puissance de l'une quelconque des revendications précédentes, comprenant au moins un commutateur de noeud (280) pour brancher et débrancher électriquement une unité de dérivation avec la première ligne de transmission.

10. Convertisseur de puissance de l'une quelconque des revendications précédentes, dans lequel les unités de dérivation sont branchées les unes aux autres au moyen de connecteurs (495) accouplables en milieu humide ou accouplables en milieu sec.

11. Convertisseur de puissance de l'une quelconque des revendications précédentes, dans lequel une unité de dérivation comprend au moins deux bras de convertisseur (331) et au moins deux bobines de réactance (333).

12. Convertisseur de puissance de l'une quelconque des revendications précédentes, le convertisseur de puissance étant un convertisseur de puissance à courant continu haute tension (CCHT).

13. Convertisseur de puissance de l'une quelconque des revendications précédentes, adapté pour recevoir/ transmettre un CC/CA depuis/vers un équipement électrique de puissance à terre (20).

14. Procédé (500) de fonctionnement d'un convertisseur de puissance sous-marin, comprenant les étapes suivantes :
recevoir (510) un courant continu (CC) ;
convertir (520) le CC reçu en un courant alternatif (CA) triphasé au moyen d'au moins trois unités de dérivation, une unité de dérivation étant branchable électriquement à une première ligne de transmission pour recevoir le CC et une deuxième ligne de transmission pour délivrer le CA, l'unité de dérivation étant en outre adaptée pour convertir le CC reçu en une phase respective du CA triphasé délivré ; et
délivrer (530) un CA triphasé ;
**caractérisé en ce que**
chaque unité de dérivation est disposée dans une enceinte scellée qui est disposée séparément d'enceintes scellées des autres unités de dérivation ;
et par les étapes suivantes :
en réponse à une défaillance de fonctionnement détectée ou une maintenance d'une unité de dérivation, débrancher (540) ladite unité de dérivation de la première ligne de transmission et la deuxième ligne de transmission ; et
remplacer (550) ladite unité de dérivation par une unité de dérivation redondante, contenue dans le convertisseur de puissance sous-marin et disposée dans une enceinte scellée séparée, en branchant l'unité de dérivation redondante à la première ligne de transmission et à une ligne de phase correspondante de la deuxième ligne de transmission.

15. Procédé (500) de fonctionnement d'un convertisseur de puissance sous-marin, comprenant les étapes suivantes :
recevoir (510) un courant alternatif (CA) triphasé ;
convertir (520) le CA reçu en un courant continu (CC) au moyen d'au moins trois unités de dérivation, une unité de dérivation étant branchable électriquement à la première ligne de transmission pour délivrer le CC et une deuxième ligne de transmission pour recevoir le CA, l'unité de dérivation étant en outre adaptée pour convertir une phase respective du CA triphasé reçu en CC ; et
délivrer (530) un CC ;
**caractérisé en ce que**
chaque unité de dérivation est disposée dans une enceinte scellée qui est disposée séparément d'enceintes scellées des autres unités de dérivation ;
et par les étapes suivantes :
en réponse à une défaillance de fonctionnement détectée ou une maintenance d'une unité de dérivation, débrancher (540) ladite unité de dérivation de la première ligne de transmission et la deuxième ligne de transmission ;
remplacer (550) ladite unité de dérivation par une unité de dérivation redondante, contenue dans le convertisseur de puissance sous-marin et disposée dans une enceinte scellée séparée, en branchant l'unité de dérivation redondante à la première ligne de transmission et à une ligne de phase correspondante de la deuxième ligne de transmission ; et
délivrer (530) un CC.
